# EUROPEAN PATENT SPECIFICATION

(11) **EP 3 922 087 B1**
(45) Date of publication and mention of the grant of the patent: **14.12.2022**
(21) Application number: 20705463.6
(22) Date of filing: 03.02.2020
(51) Int. Cl.: H05K 7/14

(54) **RACK INSTALLATION SUPPORT**
GESTELLINSTALLATIONSTRÄGER
SUPPORT D'INSTALLATION DE RACK

(30) Priority: 04.02.2019 GB 201901484
(43) Date of publication of application: 15.12.2021
(73) Proprietor: VODAFONE LIMITED, Newbury Berkshire RG14 2FN (GB)
(72) Inventor: HANCOCK, Paul, Newbury Berkshire RG14 2FN (GB); HOLT, Mark, Newbury Berkshire RG14 2FN (GB); PICKERING, Ken, Andover Hampshire SP10 3TJ (GB); PICKERING, Lyn, Andover Hampshire SP10 3TJ (GB)
(74) Representative: Boult Wade Tennant LLP
(86) International application number: PCT/GB2020/050242
(87) International publication number: WO 2020/161476

(56) References cited:
- EP-A1- 0 996 205
- US-A1- 2009 101 603

## Description

### Technical Field

The present disclosure concerns an apparatus for use as a support, and more specifically, a support for use in rack installations.

### Background

Installations of electronics equipment modules, e.g. communication or server equipment, in a rack environment can present challenges to the person or persons carrying out the installation. Particularly, some equipment is of significant bulk, and may be of suitable bulk to necessitate the attendance of more than one person to carry out the installation.

The attendance of more than one person may not only be time inefficient, but may also present significant expense to a customer in having multiple persons attend, despite their needing to participate in only a small part of the installation task.

Moreover, Health and Safety requirements may present regulations to which persons installing electronics equipment modules must adhere, which may necessitate the attendance of more than one person for a small part of the installation task.

EP 0996205 discloses a support including a single blank bent into a support area with two support sections bent at right angles towards the same side forming a U-shaped main section. The continuation of the support area forms an insert section bent at a right angle from the support sections. The insert section has pins to set into holes of a row of holes on an angle bracket profile. The pins slot into the openings of the angle bracket and a sprung pin provides pressure parallel to the slot in attachment section. The support unit is firmly held on the angle bracket profile by the pin pressure. A section of a corner profile support having inserts and the sprung pin, is mounted to clamp the support securely. The inserts slot into the holes, and the sprung pin presses onto the leg of the corner profile lying opposite the hole profile.

US 2009/101603 discloses a rack rail system engageable with a post of a rack. The rack rail system includes a rail assembly and a flange provided on at least an end of the rail assembly. The flange includes a pin insertable into an aperture of the post when the flange is adjacent to the post. The rack rail system further includes a clamp pivotably connected to the flange and movable from an open position and a closed position. The clamp receives both the post and the flange in the closed position.

### Summary of the Disclosure

Against this background, the present disclosure provides a rack installation support configured to be releasably cantilever-mounted to a vertical rack rail of a rack;
the rack installation support comprising a body which extends from a proximal end to a distal end;
the proximal end comprising an attachment portion configured to be cantilever-mounted to the vertical rack rail in use;
the distal end configured to be a free end that in use extends into a void space of the rack;
the body comprising an upper support surface for supporting an electronics equipment module;
the rack installation support further comprising a retaining mechanism for releasably retaining the attachment portion in contact with the vertical rack rail
wherein the attachment portion is shaped such that the body, in use, extends at an angle of 20° to 40° to a side of the rack.

The body may comprise a sidewall and the upper support surface may comprise an upper flange that extends from an upper edge of the sidewall. The body may further comprise a lower flange that may extend from a lower edge of the sidewall.

The proximal end of the body may comprise one or more legs. The body may comprise a sidewall and the upper support surface may comprise an upper flange that may extend from an upper edge of the sidewall; the body may further comprise a lower flange that may extend from a lower edge of the sidewall; and the one or more legs may be an extension of the upper flange and/or the lower flange.

The proximal end of the body may comprise an upper leg and a lower leg.

The attachment portion may be shaped such that the body, in use, extends at an angle of 25° to 35° to a side of the rack.

The attachment portion may comprise a plurality of projections sized and shaped to engage in apertures provided in the vertical rack rail. The attachment portion of the body may comprise a mounting plate and the plurality of projections may extend from the mounting plate.

The retaining mechanism may comprise a clamp which, in use, clamps the attachment portion against the vertical rack rail. The clamp, in use, may clamp the mounting plate against a front flange of the vertical rack rail. The clamp may comprise a U-shaped channel that, in use, is engaged over the mounting plate and the front flange of the vertical rack rail. The clamp may be rotatably mounted to the mounting plate. The clamp may comprise a first lever which can be pressed to engage the clamp with the vertical rack rail and a separate, second lever that can be pressed to disengage the clamp from the vertical rack rail.

The body may be a rigid body. The retaining mechanism may be configured to rigidly mount the body to the vertical rack rail. For example, so that the body does not pivot about a vertical axis of the vertical rack rail.

The present disclosure further provides a rack installation kit comprising two rack installation supports as described above. One of the two rack installation supports may be a left-hand support and the other may be a right-hand support, wherein the left-hand support and right-hand support may be mirror-images of each other.

The present disclosure further provides a rack installation comprising:
a rack having at least one vertical rack rail and defining a void space for receiving an electronics equipment module; and
at least one rack installation support as already described releasably cantilever-mounted to the vertical rack rail of the rack;
the distal end extending freely into the void space of the rack.

The at least one rack installation support may comprise a left-hand rack installation support and a right-hand rack installation support; wherein the distal ends of the left-hand rack installation support and the right-hand rack installation support may be separated by a gap.

The attachment portion of each of the left-hand rack installation support and the right-hand rack installation support may be shaped such that the distal ends of the bodies converge towards each other, with each body extending at an angle of 20° to 40°, preferably 25° to 35° to a respective side of the rack.

### Brief Description of the Drawings

One or more embodiments of the disclosure will now be described, by way of example only, with reference to the accompanying drawings in which:
Figure 1 shows a left-hand and a right-hand rack installation support according to the present disclosure mounted to a rack;
Figure 2 shows a close up view of the left-hand rack installation support of Figure 1;
Figure 3 shows a perspective view of the right-hand rack installation support of Figure 1
Figure 4 shows a perspective view of the left-hand rack installation support of Figure 1;
Figure 5 shows a bottom plan view of a main part of the left-hand installation support of Figure 4;
Figure 6 shows a side view of the main part of Figure 5;
Figure 7 shows an end view of the main part of Figure 5;
Figure 8 shows a side view of a clasp of the left-hand rack installation support of Figure 4;
Figure 9 shows an end view of the clasp of Figure 8;
Figure 10 shows a top view of the clasp of Figure 8;
Figure 11 shows a side view of a mounting plate of the left-hand rack installation support of Figure 4;
Figure 12 shows a top view of the mounting plate of Figure 11; and
Figure 13 shows an end view of the left-hand installation support of Figure 4 showing the mounting plate and clasp assembled to the main part.

### Detailed Description

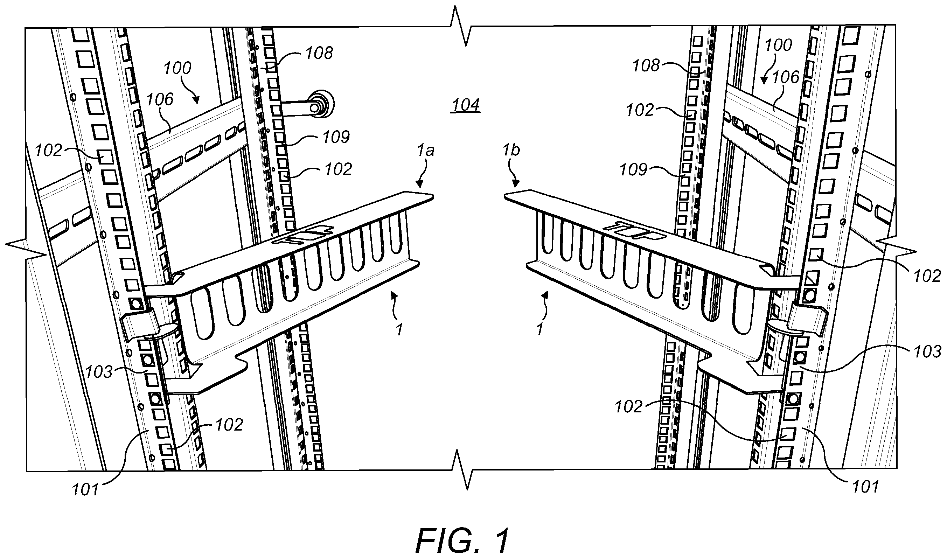

Figure 1 shows a rack 100 comprising a plurality of front vertical rack rails 101, a plurality of rear vertical rack rails 108, and a plurality of horizontal supports 106 which extend there between to define a void space 104. The void space 104 may accommodate one or more electronics equipment modules (not shown) which may be mounted, directly or indirectly, to the front vertical rack rails 101 and optionally also to the rear vertical rack rails 108.

The vertical rack rails 101, 108 are provided with a plurality of mounting holes 102 along their length. The mounting holes 102 may be threaded or unthreaded. As shown in Figure 1, the mounting holes 102 in the front vertical rack rails 101 may be arranged in a front flange 103 of the front vertical rack rails 101. Similarly, the mounting holes 102 in the rear vertical rack rails 108 may be arranged in a rear flange 109 of the rear vertical rack rails 108.

In the present disclosure the term 'rack' is used to refer to a frame or enclosure for mounting one or more electronic equipment modules. The frame or enclosure may be of various sizes. Non-limiting examples include the standardized sizes of 19 inch (483 mm), 21 inch (535 mm) and 23 inch (580 mm) racks.

Two rack installation supports 1 are shown mounted to the rack 100. A left-hand (as viewed in Figure 1) rack installation support 1a and a right-hand (as viewed in Figure 1) rack installation support 1b may be provided. The left-hand rack installation support 1a and the right-hand rack installation support 1b may be mirror images of each other.

The rack installation supports 1 may provide temporary support for an electronics equipment module during installation of the electronics equipment module in the rack 100 as will be described further below.

The rack installation supports 1 may be mounted to the rear vertical rail racks 108 but may preferably be mounted to the more accessible front vertical rail racks 101 as shown in Figure 1.

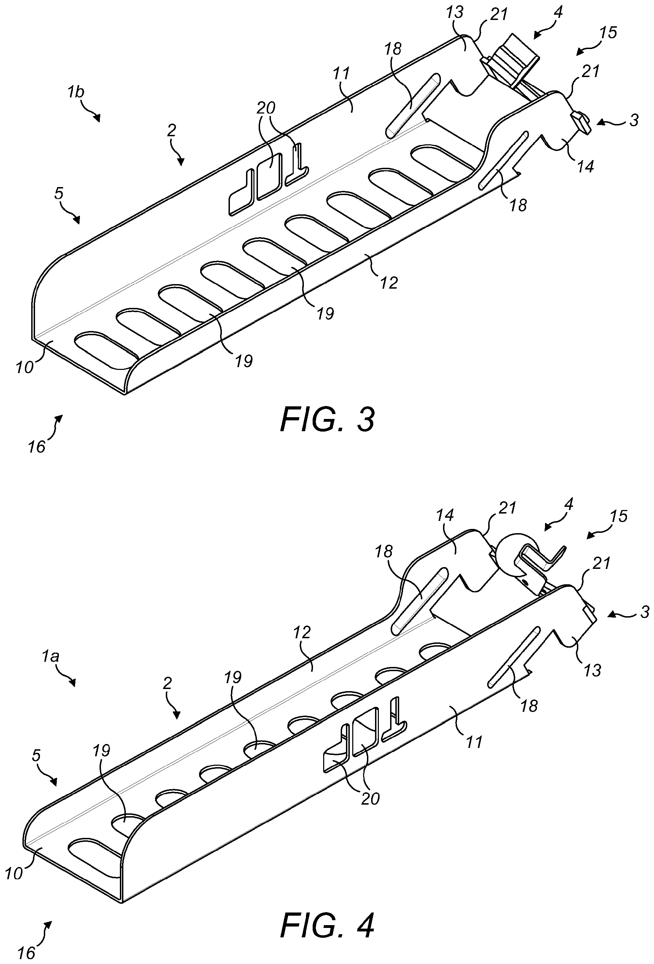

A right-hand rack installation support 1b is shown in Figure 3. A left-hand rack installation support 1a is shown in Figure 4. In the following description the features of the rack installation supports 1 will be described in detail with reference to Figures 4 to 13 which show one or more parts of the left-hand rack installation support 1a. This description applies equally to the both rack installation supports 1a and 1b, which may only differ from each other due to being mirror images of each other.

As shown in Figure 4, the rack installation support 1 comprises a body 2 which extends from a proximal end 15 to a distal end 16. The proximal end 15 comprises an attachment portion configured to be cantilever-mounted to the vertical rack rail 101, 108 in use. The distal end 16 is configured to be a free end that in use extends into the void space 104 of the rack 100. The body 2 comprises an upper support surface for supporting an electronics equipment module. The rack installation support 1 further comprises a retaining mechanism 4 for releasably retaining the attachment portion in contact with the vertical rack rail 101, 108.

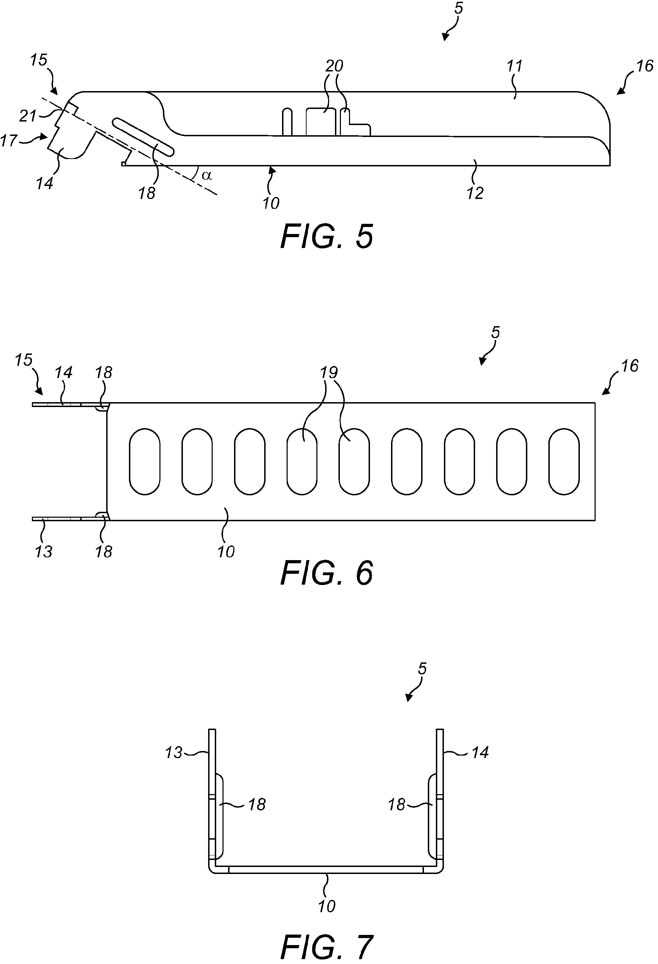

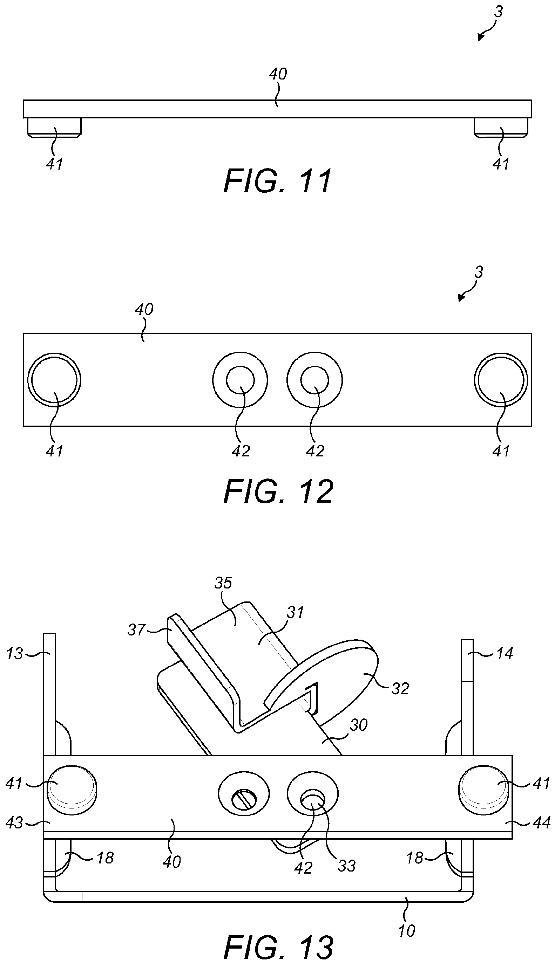

The body 2 as shown in Figure 4 may comprise a main part 5 and a mounting plate 3 that may be assembled together. The main part 5 may be formed as a single unitary piece. the mounting plate 3 may be formed as a single unitary piece. The main part 5 is shown in Figures 5 to 7. The mounting plate 3 is shown in Figures 11 and 12. The main part 5 and the mounting plate 3 may be formed from any suitable material that has the necessary strength and rigidity to function as a support in a rack environment. It is envisaged that the main part 5 and the mounting plate 3 may be a metal construction. For example, the main part 5 and the mounting plate 3 may be formed from steel. Alternatively, the main part 5 and the mounting plate 3 may be a fibre-glass, carbon fibre, or a composite material construction. An optional protective coating may be applied to the body 2, for example, a paint or powder-coated finish.

The main part 5 and the mounting plate 3 may be rigidly connected to each other. In one example the main part 5 and the mounting plate 3 may be welded together. Alternatively, the main part 5 and the mounting plate 3 may be bonded together using adhesive or similar means. The body 2 may be a rigid body.

As shown in Figures 4 to 7, the body 2 may comprise a sidewall 10 and an upper flange 11. The upper flange 11 may extend from an upper edge of the sidewall 10, preferably perpendicularly. The upper support surface may be provided by an upper face of the upper flange 11. The body may further comprise a lower flange 12 that may extend from a lower edge of the sidewall 10, preferably perpendicularly. The lower flange 12 may extend a shorter distance from the sidewall 10 than the upper flange 11. The lower flange 12 may be provided to make the rack installation support 1 easier to grasp and/or manipulate by a user, and may also reduce the likelihood of a sharp edge being presented on the lower side of the rack installation support 1. A distal end of the upper flange 11 and/or the lower flange 12 may be rounded.

The sidewall 10 may comprise a plurality of apertures 19 which may serve to reduce the mass of the rack installation support 1 without compromising its structural strength. The upper flange 11 may be provided with a plurality of apertures 20. The apertures 20 may provide a visual indication to a user informing them of a correct orientation for use of the left-hand rack installation support 1a. In the illustrated example of Figure 4, the apertures 20 spell out the word 'TOP' indicating that the left-hand rack installation support 1a should be mounted to a rack with this surface uppermost.

The proximal end 15 of the body 2 may comprise one or more legs 13, 14. The one or more legs 13, 14 may comprise at least a portion of the attachment portion.

The one or more legs may be formed as an extension of the upper flange 11 and/or the lower flange.12. In the illustrated example of Figure 4, an upper leg 13 and a lower leg 14 are provided. The upper leg 13 may be an extension of the upper flange 11 that extends proximally beyond a proximal end of the sidewall 10. The lower leg 14 may be an extension of the lower flange 12 that extends proximally beyond the proximal end of the sidewall 10.

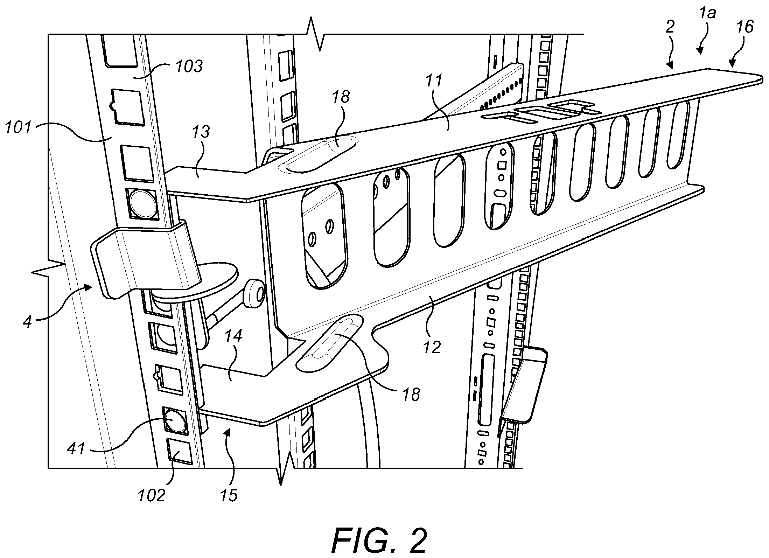

One or more of the legs 13, 14 may be provided with a stiffening feature. The stiffening feature may function to increase the bending stiffness of the relatively narrow legs 13, 14. As shown in Figure 4, the or each stiffening feature may be an indentation 18 in the legs 13, 14. The or each indentation 18 may extend along a portion, preferably a major portion, of the legs 13, 14. The or each indentation 18 may also extend into the adjoining upper flange 11 and or lower flange 12. The or each indentation 18 may be a concave indentation when viewed from an exterior of the body 2, i.e. the or each indentation 18 may extend inwardly into an interior of the body 2 as most clearly seen in Figure 2.

Referring to Figure 5, a proximal edge 21 of the upper leg 13 and the lower leg 14 may be angled relative to the sidewall 10 such that the body 2, in use when mounted to the vertical rack rail 101, 108, extends at an angle of 20° to 40°, preferably 25° to 35° to a side of the rack 100 as exemplified in Figure 1. This may be configured as illustrated in Figure 5 by setting an angle α to 20° to 40°, preferably 25° to 35°, where angle α is the angle between the plane of sidewall 10 and a line normal to the proximal edges 21.

The proximal edges 21 may be provided with a cut-out 17 as shown in Figure 5 which may be sized and shaped to receive the mounting plate 3 as shown in Figure 4.

As shown in Figures 11 and 12, the mounting plate 3 may comprise an elongate body 40 that may comprise a plurality of projections 41 sized and shaped to engage in the mounting holes 102 provided in the vertical rack rail 101, 108. The mounting plate 3 may comprise at least a portion of the attachment portion.

The plurality of projections 41 may comprise two, three or more projections 41. The projections 41 may be shaped to match the mounting holes 102. The projections 41 may be sized to be smaller than an internal diameter of the mounting holes 102. Preferably two projections 41 are provided. The two projections 41 may be provided at opposite ends of the elongate body 40. The two projections 41 may have a centre spacing of 75mm.

As noted above, the mounting plate 3 may be rigidly connected to the main part 5. The mounting plate 3 may be connected to the main part 5 such that an upper end 43 of the elongate body 40 is flush with the upper face of the upper leg 13 and/or a lower end 44 of the elongate body 40 is flush with a lower face of the lower leg 14. Alternatively, one or both of the upper end 43 and the lower end 44 may extend beyond the respective face of the respective leg 13, 14. For example, in the example shown in Figure 13 the mounting plate 3 may be connected to the main part 5 such that the lower end 44 of the elongate body 40 extends beyond the lower face of the lower leg 14. Advantageously, configuring the elongate body 40 to be longer than the spacing between the upper face of the upper leg 13 and the lower face of the lower leg 14 may permit the elongate body 40 to be long enough to space apart the protrusions 41 sufficiently while minimising the size and weight of the main part 5, e.g. the main part 5 may be configured to be narrower than the mounting plate 3.

The elongate body 40 may be provided with one or more apertures 42 which as discussed below may be used to rotatably mount the retaining mechanism 4 to the mounting plate 3. The apertures 42 may be counter-sunk as shown in Figure 12.

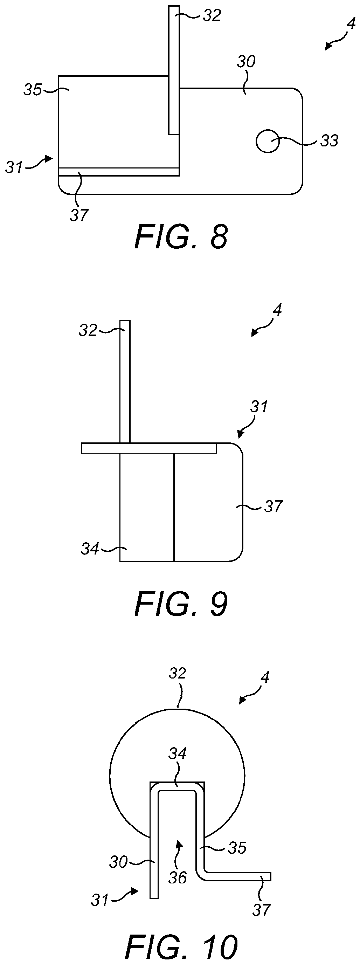

As shown in Figures 8 to 10 and 13, the retaining mechanism 4 may comprise a clamp which, in use, may clamp the attachment portion against the vertical rack rail 101, 108. Advantageously, the retaining mechanism 4 may be configured to rigidly mount the body 2 to the vertical rack rail 101, 108. For example, so that the body 2 does not pivot about a vertical axis of the vertical rack rail 101, 108.

The clamp may comprise a body plate 30 which may be provided with an aperture 33, which is preferably located off-centre. A first extension 31 may extend from the body plate 30. The first extension 31 may comprise a first portion 34, a second portion 35 and a third portion 37. The body plate 30, first portion 34 and second portion 35 may be shaped to define a channel 36 there between. The channel 36 may be U-shaped. The third portion 37 may define a first lever.

A second extension 32 may extend from the body plate 30 and or the first extension 31. The second extension 32 may define a second lever. The second lever may be orientated perpendicularly to the first lever. For example, the second extension 32 may be orientated perpendicularly to the third portion 37.

The clamp may be rotatably mounted to the mounting plate 3 using a screw, bolt or equivalent (not shown in Figure 13) that may pass through one of the apertures 42 of the mounting plate 3 and the aperture 33 of the body plate 30. Two apertures 42 may be provided in the mounting plate 3. It is envisaged that one of the apertures 42 will be utilised when the rack installation support is a left-hand version and the other will be utilised when the rack installation support is a right-hand version.

The retaining mechanism 4 may be formed from any suitable material that has the necessary strength and rigidity to function as a retaining mechanism in a rack environment. It is envisaged that the retaining mechanism 4 may be a metal construction. For example, the retaining mechanism 4 may be formed from steel. Alternatively, the retaining mechanism 4 may be a fibre-glass, carbon fibre, or a composite material construction. An optional protective coating may be applied to the retaining mechanism 4, for example, a paint or powder-coated finish.

An example of use of the rack installation support 1 is shown in Figures 1 and 2. The rack installation support 1 may be used to support one or more electronics equipment modules, e.g. communication or server equipment during installation, without the need for multiple persons. One or more rack installation supports 1 may be used. Two, three or more rack installation supports 1 may be used simultaneously depending on the size, shape and mass of the module(s) to be installed. In a typical example, as shown in Figure 1, two rack installation supports 1 may be used - a left-hand rack installation support 1a and a right-hand rack installation support 1b.

The body 2, when mounted to the vertical rack rail 101, 108, may extend at an angle of 20° to 40°, preferably 25° to 35° to a side of the rack 100. This may allow the rack installation supports 1 to provide support in a mid-region of the void space 104. The left-hand rack installation support 1a and the right-hand rack installation support 1b may converge towards one another in a 'V' configuration. The distal ends 16 of the left-hand rack installation support 1a and the right-hand rack installation support 1b may be separated by a gap.

Each rack installation support 1 may be releasably cantilever-mounted to a single vertical rack rail 101, 108 of the rack 100. Advantageously, this may avoid the need for any additional point of support for the rack installation support 1. In addition, the rack installation supports 1 may be used without adaption in racks 100 of differing widths since any change in width of the rack 100 will only result in a change in the size of the gap between the distal ends 16 but will not affect the mode or mean of mounting the rack installation supports 1.

The process of mounting and dismounting the rack installation supports 1 is straightforward and may be accomplished in a tool-free manner. In particular, the retaining mechanism 4 may be configured to be tool-free.

First, the second lever of the second extension 32 may be pressed, for example by a finger or thumb, to rotate the clamp of the retaining mechanism 4 into a position, such as that shown in Figure 13, where the first extension 31 is clear of the elongate body 40 of the mounting plate 3. Next the rack installation support 1 is offered up to a vertical rack rail 101, 108 and aligned so as to pass the projections 41 through mounting holes 102 in the vertical rack rail 101, 108. In this way the elongate body 40 of the mounting plate 3 may be brought into proximity with the flange 103, 109, preferably into face-to-face contact. To complete mounting, the clamp may be rotated by pressing on the first lever, i.e. the third portion 37, for example by a finger or thumb, to rotate the clamp of the retaining mechanism 4 into a position, such as that shown in Figures 1 and 2, where the flange 103, 109 and the elongate body 40 are sandwiched in the channel 36 of the clamp. The width of the channel 36 (i.e. length of first portion 34) may be configured to ensure that the body plate 30 and the second portion 35 squeeze together and clamp the flange 103, 109 and the elongate body 40.

Once mounted the body 2 may function as an arm that extends in a cantilever-manner into the void space 104. The rack installation support 1 may be rigidly mounted to the vertical rack rail 101, 108. For example, so that the body 2 does not pivot about the vertical axis of the vertical rack rail 101, 108. If required additional rack installation arms can be mounted.

The electronics equipment module may then be installed using the upper support surface(s) provided by the upper flange(s) 11 to provide a temporary means of support. For example, the upper support surface(s) may provide a bearing surface against which the electronics equipment module may be rested during installation.

Once the electronics equipment module has been installed and secured, the rack installation supports 1 may then be removed by reversing the process described above.

A rack installation kit may be provided which may comprise two or more rack installation supports as described above. For example, the rack installation kit may comprise a left-hand rack installation support 1a and a right-hand rack installation support 1b.

The upper flange 11 and or the lower flange 12 may take a different shape or form to those shown in the Figures, in dependence upon the intended application of the rack installation support 1. If the item to be supported is particularly large or cumbersome, the upper flange 11 and or the lower flange 12 may be longer, deeper, or a combination thereof. Additionally, in some embodiments, the upper flange 11 and or the lower flange 12 may include a non-slip or other high friction surface to aid in the support of the equipment being installed.

When used in this specification and claims, the terms "comprises" and "comprising" and variations thereof mean that the specified features, steps or integers are included. The terms are not to be interpreted to exclude the presence of other features, steps or components.

## Claims

1. A rack installation support (1) configured to be releasably cantilever-mounted to a vertical rack rail (101) of a rack (100);
the rack installation support (1) comprising a body (2) which extends from a proximal end (15) to a distal end (16);
the proximal end (15) comprising an attachment portion configured to be cantilever-mounted to the vertical rack rail (101) in use;
the distal end (16) configured to be a free end that in use extends into a void space (104) of the rack (100);
the body 2) comprising an upper support surface for supporting an electronics equipment module;
the rack installation support (1) further comprising a retaining mechanism (4) for releasably retaining the attachment portion in contact with the vertical rack rail (101),
**characterised in that** the attachment portion is shaped such that the body (2), in use, extends at an angle of 20° to 40° to a side of the rack.

2. A rack installation support (1) as claimed in claim 1, wherein the body (2) comprises a sidewall (10) and the upper support surface comprises an upper flange (11) that extends from an upper edge of the sidewall (10); and
wherein, optionally, the body (2) further comprises a lower flange (12) that extends from a lower edge of the sidewall (10).

3. A rack installation support (1) as claimed in any preceding claim, wherein the proximal end (15) of the body (2) comprises one or more legs (13, 14).

4. A rack installation support (1) as claimed in claim 1, wherein the body (2) comprises a sidewall (10) and the upper support surface comprises an upper flange (11) that extends from an upper edge of the sidewall (10); the body (2) further comprises a lower flange (12) that extends from a lower edge of the sidewall (10); and the one or more legs (13, 14) are an extension of the upper flange (11) and/or the lower flange (12).

5. A rack installation support (1) as claimed in claim 3 or claim 4, wherein the proximal end (15) of the body (2) comprises an upper leg (13) and a lower leg (14).

6. A rack installation support (1) as claimed in any preceding claim, wherein:
the attachment portion is shaped such that the body (2), in use, extends at an angle of 25° to 35° to a side of the rack; and/or
the attachment portion comprises a plurality of projections (41) sized and shaped to engage in apertures provided in the vertical rack rail (101) and, optionally, the attachment portion of the body (2) comprises a mounting plate (3) and the plurality of projections (41) extend from the mounting plate (3).

7. A rack installation support (1) as claimed in any preceding claim, wherein the retaining mechanism (4) comprises a clamp which, in use, clamps the attachment portion against the vertical rack rail (101); wherein optionally the clamp, in use, clamps the mounting plate (3) against a front flange (103) of the vertical rack rail (101).

8. A rack installation support (1) as claimed in claim 7, wherein the clamp comprises a U-shaped channel (36) that, in use, is engaged over the mounting plate (3) and the front flange (103) of the vertical rack rail (101), wherein optionally
the clamp is rotatably mounted to the mounting plate.

9. A rack installation support as claimed in claim 7 or claim 8, wherein the clamp comprises a first lever which can be pressed to engage the clamp with the vertical rack rail (101) and a separate, second lever that can be pressed to disengage the clamp from the vertical rack rail (101).

10. A rack installation support as claimed in any preceding claim, wherein the body (2) is a rigid body.

11. A rack installation kit comprising two rack installation supports (1) as claimed in any preceding claim.

12. A rack installation kit as claimed in claim 11, wherein one of the two rack installation supports (1) is a left-hand support and the other is a right-hand support, wherein the left-hand support and right-hand support are mirror-images of each other.

13. A rack installation comprising:
a rack (100) having at least one vertical rack rail (101) and defining a void space (104) for receiving an electronics equipment module; and
at least one rack installation support (1) in accordance with any preceding claim releasably cantilever-mounted to the vertical rack rail of the rack (101);
the distal end (16) extending freely into the void space (104) of the rack (100).

14. A rack installation as claimed in claim 13, wherein the at least one rack installation support (1) comprises a left-hand rack installation support and a right-hand rack installation support; wherein the distal ends (16) of the left-hand rack installation support and the right-hand rack installation support are separated by a gap.

15. A rack installation as claimed in claim 14, wherein the attachment portion of each of the left-hand rack installation support and the right-hand rack installation support is shaped such that the distal ends (16) of the bodies converge towards each other, with each body extending at an angle of 20° to 40°, preferably 25° to 35° to a respective side of the rack (100).

## Patentansprüche

1. Gestellinstallationsträger (1), so konfiguriert, dass er abnehmbar fliegend an einer vertikalen Gestellschiene (101) eines Gestells (100) gelagert ist;
wobei der Gestellinstallationsträger (1) einen Körper (2) umfasst, der sich von einem proximalen Ende (15) zu einem distalen Ende (16) erstreckt;
wobei das proximale Ende (15) einen Befestigungsabschnitt umfasst, so konfiguriert, dass er fliegend an der sich in Gebrauch befindlichen vertikalen Gestellschiene (101) gelagert ist;
wobei das distale Ende (16) so konfiguriert ist, dass es ein freies Ende ist, das sich in Gebrauch in einen leeren Raum (104) des Gestells (100) erstreckt;
wobei der Körper 2) eine obere Trägerfläche zur Abstützung eines Elektronikausrüstungsmoduls umfasst;
wobei der Gestellinstallationsträger (1) ferner einen Haltemechanismus (4) zum abnehmbaren Halten des Befestigungsabschnittes umfasst, der in Kontakt mit der vertikalen Gestellschiene (101) ist,
**dadurch gekennzeichnet, dass** der Befestigungsabschnitt derart geformt ist, dass der Körper (2) sich in Gebrauch in einem Winkel von 20° bis 40° zu einer Seite des Gestells erstreckt.

2. Gestellinstallationsträger (1) nach Anspruch 1, wobei der Körper (2) eine Seitenfläche (10) umfasst und die obere Trägerfläche einen oberen Flansch (11) umfasst, der sich von einer oberen Kante der Seitenfläche (10) erstreckt; und
wobei der Körper (2) optional ferner einen unteren Flansch (12) umfasst, der sich von einer unteren Kante der Seitenfläche (10) erstreckt.

3. Gestellinstallationsträger (1) nach einem der vorhergehenden Ansprüche, wobei das proximale Ende (15) des Körpers (2) ein oder mehrere Beine (13, 14) umfasst.

4. Gestellinstallationsträger (1) nach Anspruch 1, wobei der Körper (2) eine Seitenfläche (10) umfasst und die obere Trägerfläche einen oberen Flansch (11) umfasst, der sich von einer oberen Kante der Seitenfläche (10) erstreckt; wobei der Körper (2) ferner einen unteren Flansch (12) umfasst, der sich von einer unteren Kante der Seitenfläche (10) erstreckt; und wobei es sich bei dem einen oder den mehreren Beinen (13, 14) um eine Verlängerung des oberen Flansches (11) und/oder des unteren Flansches (12) handelt.

5. Gestellinstallationsträger (1) nach Anspruch 3 oder Anspruch 4, wobei das proximale Ende (15) des Körpers (2) ein oberes Bein (13) und ein unteres Bein (14) umfasst.

6. Gestellinstallationsträger (1) nach einem der vorhergehenden Ansprüche, wobei:
der Befestigungsabschnitt derart geformt ist, dass der Körper (2) sich in Gebrauch in einem Winkel von 25° bis 35° zu einer Seite des Gestells erstreckt; und/oder
der Befestigungsabschnitt eine Vielzahl an Vorsprüngen (41) umfasst, so bemessen und geformt, dass sie in Öffnungen eingreifen, die in der vertikalen Gestellschiene (101) vorgesehen sind, und wobei der Befestigungsabschnitt des Körpers (2) optional eine Befestigungsplatte (3) umfasst und wobei sich die Vielzahl an Vorsprüngen (41) von der Befestigungsplatte (3) erstreckt.

7. Gestellinstallationsträger (1) nach einem der vorhergehenden Ansprüche, wobei der Haltemechanismus (4) eine Klemme umfasst, die in Gebrauch den Befestigungsabschnitt an der vertikalen Gestellschiene (101) festklemmt; wobei die Klemme in Gebrauch optional die Befestigungsplatte (3) an einem vorderen Flansch (103) der vertikalen Gestellschiene (101) festklemmt.

8. Gestellinstallationsträger (1) nach Anspruch 7, wobei die Klemme einen U-förmigen Kanal (36) umfasst, der in Gebrauch über der Befestigungsplatte (3) und dem vorderen Flansch (103) der vertikalen Gestellschiene (101) in Eingriff steht, wobei
die Klemme optional drehbar an der Befestigungsplatte befestigt ist.

9. Gestellinstallationsträger nach Anspruch 7 oder Anspruch 8, wobei die Klemme einen ersten Hebel umfasst, der betätigt werden kann, damit die Klemme in die vertikale Gestellschiene (101) eingreift, und einen separaten, zweiten Hebel, der betätigt werden kann, um die Klemme aus der vertikalen Gestellschiene (101) zu lösen.

10. Gestellinstallationsträger nach einem der vorhergehenden Ansprüche, wobei es sich bei dem Körper (2) um einen starren Körper handelt.

11. Gestellinstallationssatz, umfassend zwei Gestellinstallationsträger (1) nach einem der vorhergehenden Ansprüche.

12. Gestellinstallationssatz nach Anspruch 11, wobei es sich bei einem der beiden Gestellinstallationsträger (1) um einen linken Träger und bei dem anderen um einen rechten Träger handelt, wobei der linke Träger und der rechte Träger spiegelbildlich zueinander sind.

13. Gestellinstallation, umfassend:
ein Gestell (100), das mindestens eine vertikale Gestellschiene (101) aufweist und einen leeren Raum (104) zur Aufnahme eines Elektronikausrüstungsmoduls bildet; und
mindestens einen Gestellinstallationsträger (1) nach einem der vorhergehenden Ansprüche, der abnehmbar fliegend an der vertikalen Gestellschiene des Gestells (101) gelagert ist;
wobei sich das distale Ende (16) frei in den leeren Raum (104) des Gestells (100) erstreckt.

14. Gestellinstallation nach Anspruch 13, wobei der mindestens eine Gestellinstallationsträger (1) einen linken Gestellinstallationsträger und einen rechten Gestellinstallationsträger umfasst; wobei die distalen Enden (16) des linken Gestellinstallationsträgers und des rechten Gestellinstallationsträgers durch einen Spalt voneinander getrennt sind.

15. Gestellinstallation nach Anspruch 14, wobei der Befestigungsabschnitt jedes des linken Gestellinstallationsträgers und des rechten Gestellinstallationsträgers derart geformt ist, dass die distalen Enden (16) der Körper zueinander konvergierend verlaufen, wobei sich jeder Körper in einem Winkel von 20° bis 40°, vorzugsweise 25° bis 35°, zu einer jeweiligen Seite des Gestells (100) erstreckt.

## Revendications

1. Un support d'installation de baie (1) configuré de façon à être monté en porte-à-faux libérable sur un rail de baie vertical (101) d'une baie (100),
le support d'installation de baie (1) comprenant un corps (2) qui s'étend d'une extrémité proximale (15) à une extrémité distale (16),
l'extrémité proximale (15) comprenant une partie de fixation configurée de façon à être monté en porte-à-faux au rail de baie vertical (101) en utilisation,
l'extrémité distale (16) étant configurée de façon à être une extrémité libre qui, en utilisation, s'étend dans un espace vide (104) de la baie (100),
le corps (2) comprenant une surface de support supérieure destinée au support d'un module d'équipement électronique,
le support d'installation de baie (1) comprenant en outre un mécanisme de retenue (4) destiné à retenir de manière libérable la partie de fixation en contact avec le rail de baie vertical (101),
**caractérisé en ce que** la partie de fixation est façonnée de sorte que le corps (2), en utilisation, s'étende à un angle de 20° à 40° vers un côté de la baie.

2. Un support d'installation de baie (1) selon la Revendication 1, où le corps (2) comprend une paroi latérale (10) et la surface de support supérieure comprend une bride supérieure (11) qui s'étend à partir d'un bord supérieur de la paroi latérale (10), et
où, éventuellement, le corps (2) comprend en outre une bride inférieure (12) qui s'étend à partir d'un bord inférieur de la paroi latérale (10).

3. Un support d'installation de baie (1) selon l'une quelconque des Revendications précédentes, où l'extrémité proximale (15) du corps (2) comprend un ou plusieurs pieds (13, 14).

4. Un support d'installation de baie (1) selon la Revendication 1, où le corps (2) comprend une paroi latérale (10) et la surface de support supérieure comprend une bride supérieure (11) qui s'étend à partir d'un bord supérieur de la paroi latérale (10), le corps (2) comprenant en outre une bride inférieure (12) qui s'étend à partir d'un bord inférieur de la paroi latérale (10), et les un ou plusieurs pieds (13, 14) sont une extension de la bride supérieure (11) et/ou de la bride inférieure (12).

5. Un support d'installation de baie (1) selon la Revendication 3 ou 4, où l'extrémité proximale (15) du corps (2) comprend un pied supérieur (13) et un pied inférieur (14).

6. Un support d'installation de baie (1) selon l'une quelconque des Revendications précédentes, où :
la partie de fixation est façonnée de sorte que le corps (2), en utilisation, s'étende à un angle de 25° à 35° vers un côté de la baie, et/ou
la partie de fixation comprend une pluralité de saillies (41) dimensionnées et façonnées de façon à entrer en prise dans des ouvertures placées dans le rail de baie vertical (101) et, éventuellement, la partie de fixation du corps (2) comprend une plaque de montage (3) et la pluralité de saillies (41) s'étendent à partir de la plaque de montage (3).

7. Un support d'installation de baie (1) selon l'une quelconque des Revendications précédentes, où le mécanisme de retenue (4) comprend un dispositif de serrage qui, en utilisation, serre la partie de fixation contre le rail de baie vertical (101), où éventuellement le dispositif de serrage, en utilisation, serre la plaque de montage (3) contre une bride avant (103) du rail de baie vertical (101).

8. Un support d'installation de baie (1) selon la Revendication 7, où le dispositif de serrage comprend un canal en forme de U (36) qui, en utilisation, vient en prise par dessus la plaque de montage (3) et la bride avant (103) du rail de baie vertical (101), où éventuellement
le dispositif de serrage est monté rotatif à la plaque de montage.

9. Un support d'installation de baie selon la Revendication 7 ou 8, où le dispositif de serrage comprend un premier levier qui peut être pressé de façon à mettre en prise le dispositif de serrage avec le rail de baie vertical (101), et un deuxième levier distinct qui peut être pressé de façon à désengager le dispositif de serrage du rail de baie vertical (101).

10. Un support d'installation de baie selon l'une quelconque des Revendications précédentes, où le corps (2) est un corps rigide.

11. Un kit d'installation de baie comprenant deux supports d'installation de baie (1) selon l'une quelconque des Revendications précédentes.

12. Un kit d'installation de baie selon la Revendication 11, où un des deux supports d'installation de baie (1) est un support côté gauche et l'autre est un support côté droit, où le support côté gauche et le support côté droit sont des images en miroir l'un de l'autre.

13. Une installation de baie comprenant :
une baie (100) possédant au moins un rail de baie vertical (101) et définissant un espace vide (104) destiné à la réception d'un module d'équipement électronique, et
au moins un support d'installation de baie (1) selon l'une quelconque des Revendications précédentes monté en porte-à-faux libérable sur le rail de baie vertical de la baie (101),
l'extrémité distale (16) s'étendant librement dans l'espace vide (104) de la baie (100).

14. Une installation de baie selon la Revendication 13, où le au moins un support d'installation de baie (1) comprend un support d'installation de baie côté gauche et un support d'installation de baie côté droit, où les extrémités distales (16) du support d'installation de baie côté gauche et du support d'installation de baie côté droit sont séparées par un espace.

15. Une installation de baie selon la Revendication 14, où la partie de fixation de chaque support d'installation de baie parmi le support d'installation de baie côté gauche et le support d'installation de baie côté droit est façonnée de sorte que les extrémités distales (16) des corps convergent l'un vers l'autre, avec chaque corps s'étendant à un angle de 20° à 40°, de préférence de 25° à 35° vers un côté respectif de la baie (100).
